# EUROPEAN PATENT APPLICATION

(11) **EP 4 061 010 A1**
(43) Date of publication of application: **21.09.2022**
(21) Application number: 20887314.1
(22) Date of filing: 29.10.2020
(51) Int. Cl.: H04R 17/00, H01L 41/047, H01L 41/083, H01L 41/09, H01L 41/18

(54) **LAMINATED PIEZOELECTRIC ELEMENT**

(30) Priority: 12.11.2019 JP 2019204572
(71) Applicant: FUJIFILM Corporation, Tokyo 106-8620 (JP)
(72) Inventor: KAGAWA, Yusuke, Minamiashigara-shi, Kanagawa 250-0193 (JP); ASHIKAWA, Teruo, Minamiashigara-shi, Kanagawa 250-0193 (JP); HIRAGUCHI, Kazuo, Minamiashigara-shi, Kanagawa 250-0193 (JP)
(74) Representative: Klunker IP Patentanwälte PartG mbB
(86) International application number: PCT/JP2020/040624
(87) International publication number: WO 2021/095546

(57) **Abstract**

An object of the present invention is to provide a laminated piezoelectric element in which piezoelectric films are laminated, capable of easily performing connection of an electrode layer of each piezoelectric film and an external device. The piezoelectric film includes a piezoelectric layer and a laminated sheet in which an electrode layer and a protective layer are laminated, piezoelectric layers are arranged between the laminated sheets facing the electrode layer, the laminated sheet includes a protruding portion protruding from the piezoelectric layer, the protruding portion is provided with a lead-out wire attached to a surface between the electrode layer and the protective layer, and the object is achieved by contacting the lead-out wire and connecting electrode layers having a same polarity of each piezoelectric film.

## Description

### BACKGROUND OF THE INVENTION

### 1. Field of the Invention

The present invention relates to a laminated piezoelectric element used in an exciter and the like.

### 2. Description of the Related Art

So-called exciters, which are brought into contact with and attached to various articles and vibrate the articles to make a sound, are used for various usages.

For example, in an office, by attaching an exciter to a conference table, a whiteboard, a screen, or the like during a presentation, a telephone conference, or the like, a sound can be produced instead of a speaker. In a case of a vehicle such as an automobile or the like, by attaching an exciter to a console, an A pillar, a roof, or the like, a guide sound, a warning sound, music, or the like can be sounded. In addition, in a case of an automobile that does not produce an engine sound, such as a hybrid vehicle and an electric vehicle, by attaching an exciter to a bumper or the like, a vehicle approach warning sound can be produced from the bumper or the like.

As a variable element that generates vibration in such an exciter, a combination of a coil and a magnet, a vibration motor such as an eccentric motor and a linear resonance motor, and the like are known.

It is difficult to reduce a thickness of these variable elements. In particular, the vibration motor has disadvantages that a mass body needs to be increased in order to increase the vibration force, frequency modulation for controlling a degree of vibration is difficult, and a response speed is slow.

As a variable element capable of solving such a problem, as shown in JP2015-15283A, a laminated piezoelectric element in which a piezoelectric film having a piezoelectric layer interposed between electrode layers is used and a plurality of layers of piezoelectric films are laminated can be considered.

Although the piezoelectric film itself has low rigidity, the rigidity of the entire element can be increased by laminating the piezoelectric films. Moreover, a laminate of the piezoelectric films is extremely suitable since a high electric field strength can be secured without increasing a driving voltage.

### SUMMARY OF THE INVENTION

As shown in JP2015-15283A, a piezoelectric film (piezoelectric unit) has a configuration in which a piezoelectric layer (piezoelectric film) consisting of a polymer material such as a helical chiral polymer is interposed between a first electrode layer and a second electrode layer. In the laminated piezoelectric element disclosed in JP2015-15283A, a plurality of such piezoelectric films are laminated via an insulating layer.

In addition, the piezoelectric layer and the electrode layer constituting the piezoelectric film are extremely thin. For example, JP2015-15283A exemplifies 20 to 80 µm as a preferable thickness of the piezoelectric layer, and 10 to 1,000 nm as a preferable thickness of the electrode layer.

Therefore, in order to secure the strength of the piezoelectric film, it is considered that a film consisting of an insulating material such as polyethylene terephthalate is provided on both sides of the laminate of the piezoelectric layer and the electrode layer as a protective layer.

By providing such a protective layer, the strength of the piezoelectric film can be secured, and the insulating layer inserted between the piezoelectric films at the time of laminating can be unnecessary.

As disclosed in JP2015-15283A, in a laminated piezoelectric element formed by laminating a plurality of piezoelectric films, it is necessary to connect each piezoelectric film to an external device such as a power supply device for driving the piezoelectric film.

However, in the laminated piezoelectric element in which a plurality of piezoelectric films are laminated, a method for simply connecting the electrode layer of each piezoelectric film and an external device is not known.

An object of the present invention is to solve such a problem of the prior art, and to provide a laminated piezoelectric element formed by laminating a plurality of piezoelectric films, which can simply connect an electrode layer of each piezoelectric film and an external device.

In order to achieve such an object, the present invention has the following configurations.
[1] A laminated piezoelectric element in which a plurality of piezoelectric films are laminated,
   in which the piezoelectric film includes a piezoelectric layer, a first laminated sheet in which a first electrode layer and an insulating first protective layer are laminated, and a second laminated sheet in which a second electrode layer and an insulating second protective layer are laminated, and the piezoelectric layer is positioned between the first laminated sheet and the second laminated sheet with the first electrode layer and the second electrode layer facing each other,
   the first laminated sheet has a first protruding portion protruding from the piezoelectric layer, and the second laminated sheet has a second protruding portion protruding from the piezoelectric layer,
   in the first protruding portion, one end of a first lead-out wire having conductivity is connected to a surface of the first electrode layer and the other end is attached to the first electrode layer such that the first lead-out wire reaches a surface of the first protective layer from a surface of the first electrode layer, and in the second protruding portion, one end of a second lead-out wire having conductivity is connected to a surface of the second electrode layer so as to reach a surface of the second protective layer from a surface of the second electrode layer, and the other end is attached to the second protective layer such that the second lead-out wire reaches the surface of the second protective layer from a surface, and
   in the plurality of piezoelectric films, all of the first electrode layers are electrodes having the same polarity, all of the second electrode layers are electrodes having the same polarity, the first electrode layers are connected to each other by contacting the first lead-out wire, and the second electrode layers are connected to each other by contacting the second lead-out wire.
[2] The laminated piezoelectric element as described in [1], in which in a case where the plurality of laminated piezoelectric films are viewed from a normal direction of a laminate of the piezoelectric films, the first lead-out wires overlap each other and the second lead-out wires overlap each other.
[3] The laminated piezoelectric element as described in [1] or [2], including: an attaching layer which attaches adjacent piezoelectric films to each other.
[4] The laminated piezoelectric element as described in any one of [1] to [3], in which the first lead-out wire and the second lead-out wire are laminates in which a conductive attaching layer and a conductive layer are laminated, and
   in the first lead-out wire, the conductive attaching layer is attached to the surface of the first electrode layer and the surface of the first protective layer, and in the second lead-out wire, the conductive attaching layer is attached to the surface of the second electrode layer and the surface of the second protective layer.
[5] The laminated piezoelectric element as described in any one of [1] to [4], in which the piezoelectric film has no in-plane anisotropy in piezoelectric properties.
[6] The laminated piezoelectric element as described in any one of [1] to [5], in which the piezoelectric layer is a polymer composite piezoelectric body having a polymer material and piezoelectric particles.
[7] The laminated piezoelectric element as described in [6], in which the polymer material has a cyanoethyl group.
[8] The laminated piezoelectric element as described in [7], in which the polymer material is cyanoethylated polyvinyl alcohol.

According to the present invention as described above, in a laminated piezoelectric element formed by laminating a plurality of piezoelectric films, an electrode layer of each piezoelectric film and an external device can be simply connected.

### BRIEF DESCRIPTION OF THE DRAWINGS

Fig. 1 is a diagram conceptually illustrating an example of a laminated piezoelectric element of the present invention.
Fig. 2 is a diagram conceptually illustrating an example of a piezoelectric film constituting the laminated piezoelectric element illustrated in Fig. 1.
Fig. 3 is a diagram conceptually illustrating an example of the piezoelectric film.
Fig. 4 is a conceptual diagram for describing an example of a production method of a piezoelectric film.
Fig. 5 is a conceptual diagram for describing an example of the production method of a piezoelectric film.
Fig. 6 is a conceptual diagram for describing an example of the production method of a piezoelectric film.
Fig. 7 is a partially enlarged view of an example of a piezoelectric film.
Fig. 8 is a modification example of Fig. 7.
Fig. 9 is another modification example of Fig. 7.
Fig. 10 is a partially enlarged view of another example of a piezoelectric film.
Fig. 11 is a diagram conceptually illustrating an example of a method of connecting a laminated piezoelectric element and an external device of the present invention.
Fig. 12 is a diagram conceptually illustrating an example of an electroacoustic transducer using a laminated piezoelectric element of the present invention.

### DESCRIPTION OF THE PREFERRED EMBODIMENTS

Hereinafter, a laminated piezoelectric element of an embodiment of the present invention will be described in detail based on the preferred embodiments illustrated in the accompanying drawings.

Descriptions of the constituent requirements described below may be made based on representative embodiments of the present invention, but the present invention is not limited to such embodiments.

In addition, the figures shown below are conceptual diagrams for describing the present invention. Therefore, a thickness, a size, a shape, a positional relationship, and the like of each constituent member are different from the actual ones.

In the present specification, a numerical range expressed using "to" means a range including numerical values described before and after "to" as a lower limit and an upper limit.

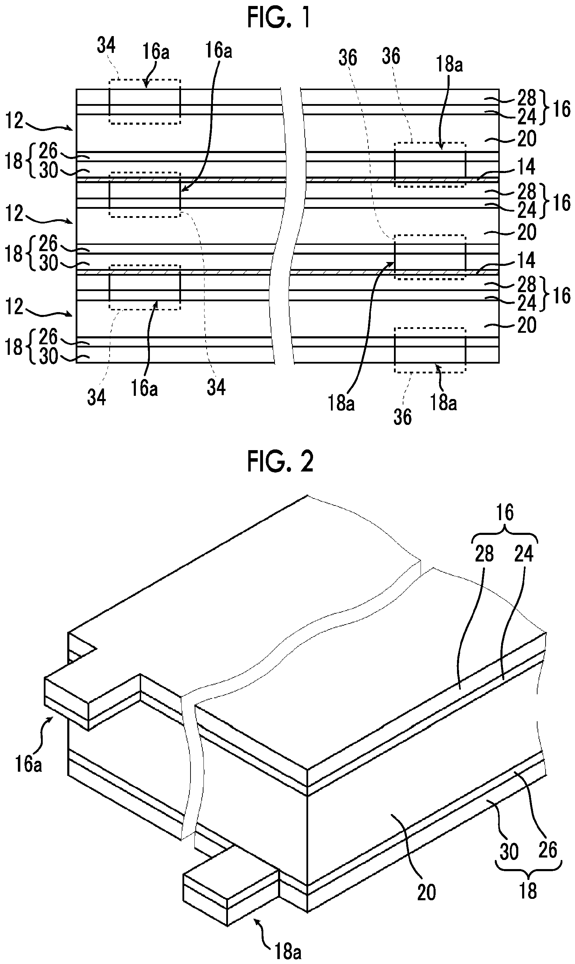

Fig. 1 conceptually illustrates an example of the laminated piezoelectric element of an embodiment of the present invention.

A laminated piezoelectric element 10 illustrated in Fig. 1 has a configuration in which three piezoelectric films 12 are laminated and adjacent piezoelectric films 12 are attached to each other by an attaching layer 14. In addition, in order to clearly show the configuration, the attaching layer 14 is hatched.

The laminated piezoelectric element 10 illustrated in Fig. 1 is formed by laminating three piezoelectric films 12, but the present invention is not limited thereto. That is, the number of laminated piezoelectric films 12 may be two layers or four or more layers as long as the laminated piezoelectric element of the embodiment of the present invention is formed by laminating a plurality of layers of the piezoelectric films 12.

Fig. 2 illustrates a partial schematic perspective view of the piezoelectric film 12.

The piezoelectric film 12 is a rectangular sheet-like material (film, plate-like material), and includes a first laminated sheet 16, a second laminated sheet 18, and a piezoelectric layer 20 which is a sheet-like material having piezoelectric properties. The first laminated sheet 16 is a laminate in which a first electrode layer 24 and a first protective layer 28 are laminated. On the other hand, the second laminated sheet 18 is a laminate in which the second electrode layer 26 and the second protective layer 30 are laminated.

The piezoelectric film 12 has a configuration in which the piezoelectric layer 20 is interposed between the first laminated sheet 16 and the second laminated sheet 18 in a state of the first electrode layer 24 and the second electrode layer 26 facing each other. That is, the piezoelectric film 12 has a configuration in which one surface of the piezoelectric layer 20 includes the first electrode layer 24 and the other surface thereof includes the second electrode layer 26, and a laminate in which the piezoelectric layer 20 is interposed between the electrode layers is interposed between the first protective layer 28 and the second protective layer 30.

In the laminated piezoelectric element 10 of the embodiment of the present invention in which three layers of the piezoelectric films 12 are laminated, the first electrode layer 24 of each piezoelectric film 12 is an electrode having the same polarity. Therefore, the second electrode layer 26 of each piezoelectric film 12 is also an electrode having the same polarity as that of the first electrode layer 24.

In the present invention, the first and second in the first laminated sheet 16 and the second laminated sheet 18, the first electrode layer 24 and the second electrode layer 26, and the like are those attached for convenience of describing the piezoelectric film 12 of the laminated piezoelectric element of the embodiment of the present invention.

That is, the first and second in the piezoelectric film 12 of the embodiment of the present invention have no technical meaning.

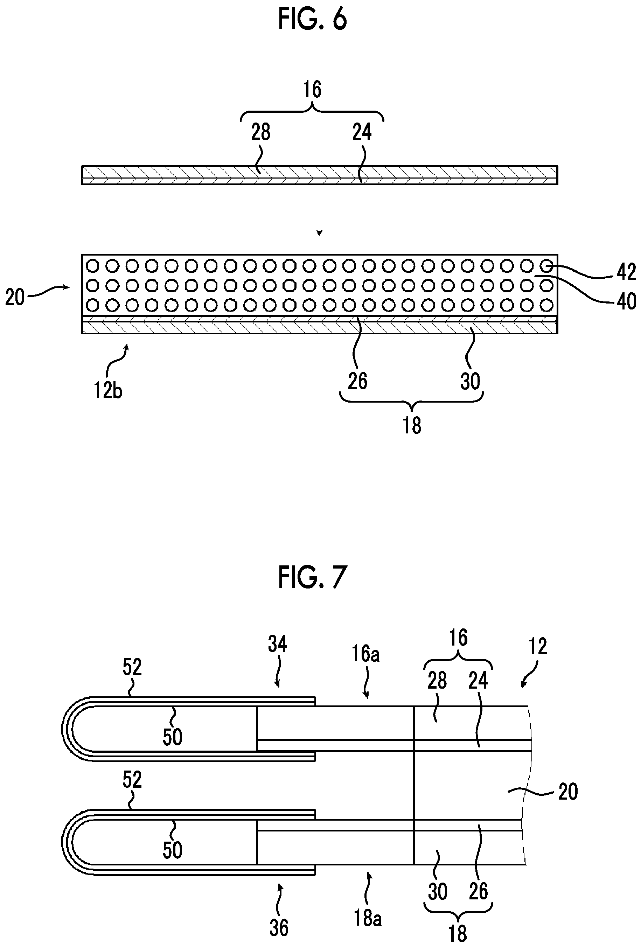

As illustrated in Fig. 2, the first laminated sheet 16 has a first protruding portion 16a protruding from the piezoelectric layer 20. Therefore, in the first protruding portion 16a, the first electrode layer 24 is exposed on a lower surface side. As illustrated in Fig 7, which will be described later, a band-like first lead-out wire 34 is attached to the first protruding portion 16a so as to reach a surface of the first protective layer 28 at an upper part in the figure from the surface of the first electrode layer 24 at a lower part in the figure.

On the other hand, the second laminated sheet 18 has a second protruding portion 18a protruding from the piezoelectric layer 20. Therefore, in the second protruding portion 18a, the second electrode layer 26 is exposed on an upper surface side. As illustrated in Fig. 7, which will be described later, a band-like second lead-out wire 36 is attached to the second protruding portion 18a so as to reach a surface of the second protective layer 30 at a lower part in the figure from the surface of the second electrode layer 26 at an upper part in the figure.

In order to clearly show the configuration of the piezoelectric film 12, the first lead-out wire 34 and the second lead-out wire 36 are shown by broken lines in Fig. 1, and the first lead-out wire 34 and the second lead-out wire 36 are omitted in Fig. 2.

The first protruding portion 16a and the second protruding portion 18a are formed on the same end face on a short side of the rectangular (oblong) piezoelectric film 12 as an example. That is, Fig. 1 is a view of the piezoelectric film 12 as viewed toward the short side having a protruding portion.

In the piezoelectric film 12 constituting the laminated piezoelectric element of the embodiment of the present invention, the first protruding portion 16a of the first laminated sheet 16 and the second protruding portion 18a of the second laminated sheet 18 are not limited to be provided on the same end face of the piezoelectric film, and various formation positions can be used. For example, the first protruding portion 16a of the first laminated sheet 16 may be formed on the end face of one short side of the rectangular piezoelectric film, and the second protruding portion 18a of the second laminated sheet 18 may be formed on the end face of the other short side of the rectangular piezoelectric film. Alternatively, the first protruding portion 16a of the first laminated sheet 16 may be formed on the end surface of one short side of the rectangular piezoelectric film, and the second protruding portion 18a of the second laminated sheet 18 may be formed on the end surface of a long side of the rectangular piezoelectric film.

In addition, a shape of the piezoelectric film, that is, the laminated piezoelectric element is not limited to a rectangular shape, and various shapes can be used. Examples of the shape of the piezoelectric film include a square, a circle, an ellipse, and the like, in addition to the rectangle.

The shape of the piezoelectric film referred to here is the shape of a main surface of the piezoelectric film. The main surface is a maximum surface of a sheet-like material (a film, a plate-like material, and a layer).

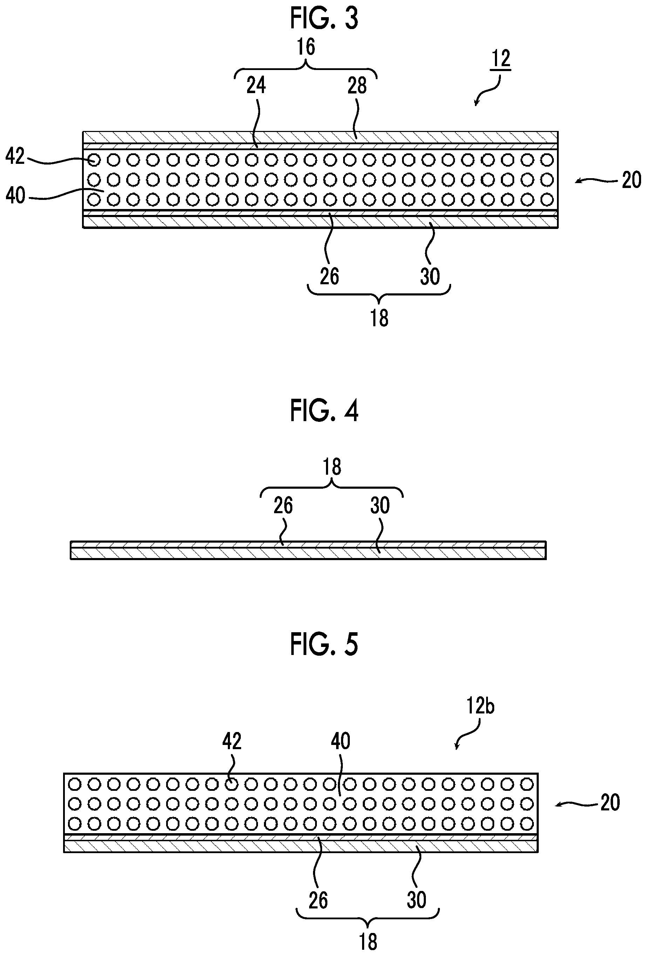

Fig. 3 conceptually illustrates an example of the piezoelectric film 12 in a cross-sectional view.

As described above, the piezoelectric film 12 has a configuration in which the piezoelectric layer 20 is interposed between the first laminated sheet 16 and the second laminated sheet 18. With this, the piezoelectric film 12 has a first electrode layer 24 laminated on one surface of the piezoelectric layer 20, a first protective layer 28 laminated on the first electrode layer 24, a second electrode layer 26 laminated on the other surface of the piezoelectric layer 20, and a second protective layer 30 laminated on the second electrode layer 26.

In Fig. 3, the first protruding portion 16a of the first laminated sheet 16 and the second protruding portion 18a of the second laminated sheet 18 are omitted. In relation to this point, the same applies to Figs. 4 to 6.

In the piezoelectric film 12, as a preferable aspect, as conceptually illustrated in Fig. 3, the piezoelectric layer 20 consists of a polymer composite piezoelectric body in which piezoelectric particles 42 are dispersed in a polymer matrix 40 consisting of a polymer material having viscoelasticity at room temperature. In the present specification, the "room temperature" indicates a temperature range of approximately 0°C to 50°C.

Here, it is preferable that the polymer composite piezoelectric body (piezoelectric layer 20) satisfies the following requisites.

### (i) Flexibility

For example, in a case of being gripped in a state of being loosely bent like a newspaper or a magazine as a portable device, the polymer composite piezoelectric body is continuously subjected to large bending deformation from the outside at a comparatively slow vibration of less than or equal to a few Hz. In this case, in a case where the polymer composite piezoelectric body is hard, large bending stress is generated to that extent, and a crack is generated at the interface between the polymer matrix and the piezoelectric particles, possibly leading to breakage. Accordingly, the polymer composite piezoelectric body is required to have suitable flexibility. In addition, in a case where strain energy is diffused into the outside as heat, the stress is able to be relieved. Accordingly, the loss tangent of the polymer composite piezoelectric body is required to be suitably large.

As described above, a flexible polymer composite piezoelectric body used as an exciter is required to be rigid with respect to a vibration of 20 Hz to 20 kHz, and be flexible with respect to a vibration of less than or equal to a few Hz. In addition, the loss tangent of the polymer composite piezoelectric body is required to be suitably large with respect to the vibration of all frequencies of less than or equal to 20 kHz.

In addition, it is preferable that the spring constant can be easily controlled by lamination according to the rigidity of a mating material to be attached. At this time, the thinner the attaching layer 14 is, the higher the energy efficiency can be. As the mating material to be attached, for example, a vibration plate is exemplified. In addition, the rigidity is, in other words, hardness, stiffness, spring constant, and the like.

In general, a polymer solid has a viscoelasticity relieving mechanism, and a molecular movement having a large scale is observed as a decrease (relief) in a storage elastic modulus (Young's modulus) or the local maximum (absorption) in a loss elastic modulus along with an increase in a temperature or a decrease in a frequency. Among them, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer composite piezoelectric body (the piezoelectric layer 20), the polymer material of which the glass transition point is room temperature, in other words, the polymer material having viscoelasticity at room temperature is used in the matrix, and thus the polymer composite piezoelectric body which is rigid with respect to a vibration of 20 Hz to 20 kHz and is flexible with respect to a vibration of less than or equal to a few Hz is realized. In particular, from a viewpoint of suitably exhibiting such behavior, it is preferable that a polymer material of which the glass transition temperature at a frequency of 1 Hz is room temperature, that is, 0°C to 50°C is used in the matrix of the polymer composite piezoelectric body.

As the polymer material having viscoelasticity at room temperature, various known materials are able to be used. Preferably, a polymer material of which the maximum value of a loss tangent Tanδ at a frequency of 1 Hz at room temperature, that is, 0°C to 50°C in a dynamic viscoelasticity test is greater than or equal to 0.5 is used.

Accordingly, in a case where the polymer composite piezoelectric body is slowly bent due to an external force, stress concentration on the interface between the polymer matrix and the piezoelectric particles at the maximum bending moment portion is relieved, and thus high flexibility can be expected.

In addition, it is preferable that, in the polymer material having viscoelasticity at room temperature, a storage elastic modulus (E') at a frequency of 1 Hz according to dynamic viscoelasticity measurement is greater than or equal to 100 MPa at 0°C and is less than or equal to 10 MPa at 50°C.

Accordingly, it is possible to reduce a bending moment which is generated in a case where the polymer composite piezoelectric body is slowly bent due to the external force, and it is possible to make the polymer composite piezoelectric body rigid with respect to an acoustic vibration of 20 Hz to 20 kHz.

In addition, it is more suitable that the relative permittivity of the polymer material having viscoelasticity at room temperature is greater than or equal to 10 at 25°C. Accordingly, in a case where a voltage is applied to the polymer composite piezoelectric body, a higher electric field is applied to the piezoelectric particles in the polymer matrix, and thus a large deformation amount can be expected.

However, in consideration of securing good moisture resistance or the like, it is suitable that the relative permittivity of the polymer material is less than or equal to 10 at 25°C.

As the polymer material having viscoelasticity at room temperature and satisfying such conditions, cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, polybutyl methacrylate, and the like are exemplified. In addition, as these polymer materials, a commercially available product such as Hybrar 5127 (manufactured by Kuraray Co., Ltd.) is also able to be suitably used. Among them, as the polymer material, a material having a cyanoethyl group is preferably used, and cyanoethylated PVA is particularly preferably used.

Furthermore, only one of these polymer materials may be used, or a plurality of types thereof may be used in combination (mixture).

The polymer matrix 40 using such a polymer material having viscoelasticity at room temperature, as necessary, may use a plurality of polymer materials in combination.

That is, in order to control dielectric properties or mechanical properties, other dielectric polymer materials may be added to the polymer matrix 40 in addition to the polymer material having viscoelasticity at room temperature such as cyanoethylated PVA, as necessary.

As the dielectric polymer material which is able to be added, for example, a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer, a polymer having a cyano group or a cyanoethyl group such as a vinylidene cyanide-vinyl acetate copolymer, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol, and a synthetic rubber such as nitrile rubber or chloroprene rubber are exemplified.

Among them, a polymer material having a cyanoethyl group is suitably used.

Furthermore, the dielectric polymer material added to the polymer matrix 40 of the piezoelectric layer 20 in addition to the polymer material having viscoelasticity at room temperature such as cyanoethylated PVA is not limited to one dielectric polymer, and a plurality of dielectric polymers may be added.

In addition, for the purpose of controlling the glass transition point Tg, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, and mica may be added to the polymer matrix 40 in addition to the dielectric polymer material.

Furthermore, for the purpose of improving adhesiveness, a viscosity imparting agent such as rosin ester, rosin, terpene, terpene phenol, and a petroleum resin may be added.

The amount of materials added to the polymer matrix 40 of the piezoelectric layer 20 in a case of materials other than the polymer material having viscoelasticity such as cyanoethylated PVA is not particularly limited, and it is preferable that a ratio of the added materials to the polymer matrix 40 is less than or equal to 30 mass%.

Accordingly, it is possible to exhibit properties of the polymer material to be added without impairing the viscoelasticity relieving mechanism of the polymer matrix 40, and thus a preferable result is able to be obtained from a viewpoint of increasing a dielectric constant, of improving heat resistance, and of improving adhesiveness between the piezoelectric particles 42 and the electrode layer.

The piezoelectric particles 42 consist of ceramics particles having a perovskite type or wurtzite type crystal structure.

As the ceramics particles forming the piezoelectric particles 42, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃) are exemplified.

The particle diameter of such piezoelectric particles 42 is not limited, and may be appropriately selected depending on the size of the piezoelectric film 12, the usage of the laminated piezoelectric element 10, and the like. The particle diameter of the piezoelectric particles 42 is preferably 1 to 10 µm.

By setting the particle diameter of the piezoelectric particles 42 to be in the range described above, a preferable result is able to be obtained from a viewpoint of allowing the piezoelectric film 12 to achieve both high piezoelectric properties and flexibility.

In Fig. 3, the piezoelectric particles 42 in the piezoelectric layer 20 are uniformly dispersed in the polymer matrix 40 with regularity, but the present invention is not limited thereto.

That is, in the piezoelectric particles 42 in the piezoelectric layer 20 are preferably uniformly dispersed, and may also be irregularly dispersed in the polymer matrix 40.

In the piezoelectric film 12, a quantitative ratio of the polymer matrix 40 and the piezoelectric particles 42 in the piezoelectric layer 20 is not limited, and may be appropriately set according to the size in the surface direction or the thickness of the piezoelectric film 12, the usage of the laminated piezoelectric element 10, properties required for the piezoelectric film 12, and the like.

The volume fraction of the piezoelectric particles 42 in the piezoelectric layer 20 is preferably 30% to 80%, and more preferably more than or equal to 50%. Therefore, the volume fraction of the piezoelectric particles 42 in the piezoelectric layer 20 is even more preferably set to 50% to 80%.

By setting the quantitative ratio of the polymer matrix 40 and the piezoelectric particles 42 to be in the range described above, it is possible to obtain a preferable result from a viewpoint of making high piezoelectric properties and flexibility compatible.

In the above-mentioned piezoelectric film 12, as a preferable aspect, the piezoelectric layer 20 is a polymer composite piezoelectric layer formed by dispersing piezoelectric particles in a polymer matrix containing a polymer material having viscoelasticity at room temperature. However, the present invention is not limited thereto, and various known piezoelectric layers used in known piezoelectric elements are able to be used as the piezoelectric layer of the piezoelectric film.

As an example, a piezoelectric layer consisting of the above-mentioned dielectric polymer material such as polyvinylidene fluoride (PVDF) and a vinylidene fluoride-tetrafluoroethylene copolymer, and a piezoelectric layer consisting of the above-mentioned piezoelectric body such as PZT, PLZT, barium titanate, zinc oxide, or BFBT are exemplified.

In the piezoelectric film 12, the thickness of the piezoelectric layer 20 is not limited, and may be appropriately set according to the usage of the laminated piezoelectric element 10, the number of laminated layers of the piezoelectric films in the laminated piezoelectric element 10, properties required for the piezoelectric film 12, and the like.

The thicker the piezoelectric layer 20, the more advantageous it is in terms of rigidity such as the stiffness of a so-called sheet-like material, but the voltage (potential difference) required to stretch and contract the piezoelectric film 12 by the same amount increases.

The thickness of the piezoelectric layer 20 is preferably 10 to 300 µm, more preferably 20 to 200 µm, and even more preferably 30 to 150 µm.

By setting the thickness of the piezoelectric layer 20 to be in the range described above, it is possible to obtain a preferable result from a viewpoint of compatibility between securing the rigidity and appropriate flexibility, or the like.

It is preferable that the piezoelectric layer 20 is subjected to a polarization treatment (poling) in the thickness direction. The polarization treatment will be described in detail later.

In the piezoelectric film 12 used in the present invention, the piezoelectric layer 20 is formed on the polymer matrix 40 consisting of a polymer material having viscoelasticity at room temperature, such as cyanoethylated PVA, as described above, and the polymer composite piezoelectric body containing the piezoelectric particles 42 is not limited.

That is, in the piezoelectric film 12 of the embodiment of the present invention, various known piezoelectric layers can be used as the piezoelectric layer.

As an example, a polymer composite piezoelectric body containing the same piezoelectric particles 42 in the matrix containing a dielectric polymer material such as the above-mentioned polyvinylidene fluoride, vinylidene fluoride-tetrafluoroethylene copolymer, and vinylidene fluoride-trifluoroethylene copolymer, a piezoelectric layer consisting of polyvinylidene fluoride, a piezoelectric layer consisting of a fluorine resin other than polyvinylidene fluoride, a piezoelectric layer obtained by laminating a film consisting of poly-L lactic acid and a film consisting of poly-D lactic acid, and the like can be used.

However, as described above, a polymer composite piezoelectric body containing the piezoelectric particles 42 in the polymer matrix 40 consisting of a polymer material having viscoelasticity at room temperature such as the above-mentioned cyanoethylated PVA can be suitably used, from a viewpoint of capable of being hard with respect to a vibration of 20 Hz to 20 kHz and soft with respect to a slow vibration of several Hz or less, obtaining excellent acoustic properties, and excellent flexibility.

As illustrated in Fig. 3, the piezoelectric film 12 in the illustrated example has a configuration in which the first electrode layer 24 is provided on one surface of the piezoelectric layer 20, the first protective layer 28 is provided thereon, the second electrode layer 26 is provided on the other surface of the piezoelectric layer 20, and the second protective layer 30 is provided thereon. Here, the second electrode layer 26 and the first electrode layer 24 form an electrode pair.

As described above, such a piezoelectric film 12 is formed by interposing a piezoelectric layer 20 between the first laminated sheet 16 in which the first electrode layer 24 and the first protective layer 28 are laminated and the second laminated sheet 18 in which the second electrode layer 26 and the second protective layer 30 are laminated, facing the electrode layer.

The piezoelectric film 12 may have an insulating layer which covers a region where the piezoelectric layer 20 is exposed for preventing a short circuit or the like.

That is, the piezoelectric film 12 has a configuration in which both surfaces of the piezoelectric layer 20 are interposed between the electrode pair, that is, the second electrode layer 26 and the first electrode layer 24, and the laminate is further interposed between the first protective layer 28 and the second protective layer 30.

As described above, in the piezoelectric film 12, the region interposed between the second electrode layer 26 and the first electrode layer 24 is stretched and contracted according to an applied voltage.

In the piezoelectric film 12, the first protective layer 28 and the second protective layer 30 have a function of covering the second electrode layer 26 and the first electrode layer 24 and applying appropriate rigidity and mechanical strength to the piezoelectric layer 20. That is, there may be a case where, in the piezoelectric film 12, the piezoelectric layer 20 consisting of the polymer matrix 40 and the piezoelectric particles 42 exhibits extremely superior flexibility under slow bending deformation but has insufficient rigidity or mechanical strength depending on the usage. As a compensation for this, the piezoelectric film 12 is provided with the first protective layer 28 and the second protective layer 30.

The first protective layer 28 and the second protective layer 30 are not limited, and various sheet-like materials can be used as long as the materials have insulating properties. As an example, various resin films are suitably exemplified.

Among them, by the reason of excellent mechanical properties and heat resistance, a resin film consisting of polyethylene terephthalate (PET), polypropylene (PP), polystyrene (PS), polycarbonate (PC), polyphenylene sulfite (PPS), polymethyl methacrylate (PMMA), polyetherimide (PEI), polyimide (PI), polyethylene naphthalate (PEN), triacetylcellulose (TAC), or a cyclic olefin-based resin is suitably used.

There is also no limitation on the thicknesses of the first protective layer 28 and the second protective layer 30. In addition, the thicknesses of the first protective layer 28 and the second protective layer 30 may basically be identical to each other or different from each other.

Here, in a case where the rigidity of the first protective layer 28 and the second protective layer 30 is too high, not only is the stretching and contracting of the piezoelectric layer 20 constrained, but also the flexibility is impaired. Therefore, it is advantageous in a case where the thicknesses of the first protective layer 28 and the second protective layer 30 are smaller unless mechanical strength or good handleability as a sheet-like material is required.

In the piezoelectric film 12, in a case where the thickness of the first protective layer 28 and the second protective layer 30 is less than or equal to twice the thickness of the piezoelectric layer 20, it is possible to obtain a preferable result from a viewpoint of compatibility between securing the rigidity and appropriate flexibility, or the like.

For example, in a case where the thickness of the piezoelectric layer 20 is 50 µm and the first protective layer 28 and the second protective layer 30 consist of PET, the thickness of the first protective layer 28 and the second protective layer 30 is preferably less than or equal to 100 µm, more preferably less than or equal to 50 µm, and even more preferably less than or equal to 25 µm.

In the piezoelectric film 12, a first electrode layer 24 is provided between the piezoelectric layer 20 and the first protective layer 28, and a second electrode layer 26 is provided between the piezoelectric layer 20 and the second protective layer 30, respectively. In the following description, the first electrode layer 24 is also referred to as the first electrode layer 24, and the second electrode layer 26 is also referred to as the second electrode layer 26.

The first electrode layer 24 and the second electrode layer 26 are provided to apply a voltage to the piezoelectric layer 20 (the piezoelectric film 12).

In the present invention, a forming material of the first electrode layer 24 and the second electrode layer 26 is not limited, and various conductors are able to be used. Specifically, metals such as carbon, palladium, iron, tin, aluminum, nickel, platinum, gold, silver, copper, titanium, chromium, and molybdenum, alloys thereof, laminates and composites of these metals and alloys, indium-tin oxide, and the like are exemplified. Among them, copper, aluminum, gold, silver, platinum, and indium-tin oxide are suitably exemplified as the first electrode layer 24 and the second electrode layer 26.

In addition, a forming method of the first electrode layer 24 and the second electrode layer 26 is not limited, and various known methods such as a vapor-phase deposition method (a vacuum film forming method) such as vacuum vapor deposition or sputtering, film formation using plating, a method of attaching a foil formed of the materials described above, and the like are able to be used.

That is, as an example, the first laminated sheet 16 is manufactured by forming the first electrode layer 24 on the first protective layer 28 by vacuum vapor deposition or the like. Similarly, as an example, the second laminated sheet 18 is manufactured by forming the second electrode layer 26 on the second protective layer 30 by vacuum vapor deposition and the like.

Among them, in particular, by the reason that the flexibility of the piezoelectric film 12 is able to be secured, a thin film made of copper, aluminum, or the like formed by using the vacuum vapor deposition is suitably used as the first electrode layer 24 and the second electrode layer 26. Among them, in particular, a thin film made of copper by the vacuum vapor deposition is suitably used.

There is no limitation on the thickness of the first electrode layer 24 and the second electrode layer 26. In addition, the thicknesses of the first electrode layer 24 and the second electrode layer 26 may basically be identical to each other or different from each other.

Here, similarly to the first protective layer 28 and the second protective layer 30 mentioned above, in a case where the rigidity of the first electrode layer 24 and the second electrode layer 26 is too high, not only is the stretching and contracting of the piezoelectric layer 20 constrained, but also the flexibility is impaired. Therefore, it is advantageous in a case where the thicknesses of the first electrode layer 24 and the second electrode layer 26 are smaller as long as electrical resistance is not excessively high.

In the piezoelectric film 12, in a case where the product of the thicknesses of the first electrode layer 24 and the second electrode layer 26 and the Young's modulus is less than the product of the thicknesses of the first protective layer 28 and the second protective layer 30 and the Young's modulus, the flexibility is not considerably impaired, which is suitable.

For example, in a case of a combination consisting of the first protective layer 28 and the second protective layer 30 formed of PET (Young's modulus: approximately 6.2 GPa) and the first electrode layer 24 and the second electrode layer 26 formed of copper (Young's modulus: approximately 130 GPa), in a case where the thickness of the first protective layer 28 and the second protective layer 30 is 25 µm, the thickness of the first electrode layer 24 and the second electrode layer 26 is preferably less than or equal to 1.2 µm, more preferably less than or equal to 0.3 µm, and particularly preferably less than or equal to 0.1 µm.

As described above, the piezoelectric film 12 preferably has a configuration in which the piezoelectric layer 20 in which the piezoelectric particles 42 are dispersed in the polymer matrix 40 containing a polymer material having viscoelasticity at room temperature is interposed between the first laminated sheet 16 in which the first electrode layer 24 and the first protective layer 28 are laminated and the second laminated sheet 18 in which the second electrode layer 26 and the second protective layer 30 are laminated.

In the piezoelectric film 12, it is preferable that the maximum value of the loss tangent (Tanδ) at a frequency of 1 Hz according to the dynamic viscoelasticity measurement exists at room temperature, and it is more preferable that a maximum value of greater than or equal to 0.1 exists at room temperature.

Accordingly, even in a case where the piezoelectric film 12 is subjected to large bending deformation from the outside at a comparatively slow vibration of less than or equal to a few Hz, it is possible to effectively diffuse the strain energy to the outside as heat, and thus it is possible to prevent a crack from being generated on the interface between the polymer matrix and the piezoelectric particles.

In the piezoelectric film 12, it is preferable that the storage elastic modulus (E') at a frequency of 1 Hz according to the dynamic viscoelasticity measurement is 10 to 30 GPa at 0°C, and 1 to 10 GPa at 50°C.

Accordingly, the piezoelectric film 12 is able to have large frequency dispersion in the storage elastic modulus (E') at room temperature. That is, the piezoelectric film 12 is able to be rigid with respect to a vibration of 20 Hz to 20 kHz, and is able to be flexible with respect to a vibration of less than or equal to a few Hz.

In addition, in the piezoelectric film 12, it is preferable that the product of the thickness and the storage elastic modulus (E') at a frequency of 1 Hz according to the dynamic viscoelasticity measurement is 1.0 × 10⁶ to 2.0 × 10⁶ N/m at 0°C, and 1.0 × 10⁵ to 1.0 × 10⁶ N/m at 50°C.

Accordingly, the piezoelectric film 12 is able to have appropriate rigidity and mechanical strength within a range not impairing the flexibility and the acoustic properties.

Furthermore, in the piezoelectric film 12, it is preferable that the loss tangent (Tanδ) at a frequency of 1 kHz at 25°C is greater than or equal to 0.05 in a master curve obtained by the dynamic viscoelasticity measurement.

Accordingly, the frequency properties of a speaker using the piezoelectric film 12 are smoothened, and thus it is also possible to decrease the changed amount of acoustic quality in a case where the lowest resonance frequency f₀ is changed according to a change in the curvature of the speaker.

Next, an example of a manufacturing method of the piezoelectric film 12 used in the laminated piezoelectric element of the embodiment of the present invention will be described with reference to conceptual view of Figs. 4 to 6.

First, as illustrated in Fig. 4, a second laminated sheet 18 is prepared in which the second electrode layer 26 is formed on the second protective layer 30. The second laminated sheet 18 may be produced by forming a copper thin film or the like as the first electrode layer 24 on the surface of the first protective layer 28 using vacuum vapor deposition, sputtering, plating, or the like.

In a case where the second protective layer 30 is extremely thin, and thus the handleability is degraded, a second protective layer 30 with a separator (temporary support) may be used as necessary. As the separator, a PET film having a thickness of 25 to 100 µm, and the like are able to be used. The separator may be removed after thermal compression bonding of the second electrode layer 26 and the second protective layer 30 and before laminating any member on the second protective layer 30.

Next, as illustrated in Fig. 5, the piezoelectric layer 20 is formed on the second electrode layer 26 of the second laminated sheet 18, and the laminate 12a in which the second laminated sheet 18 and the piezoelectric layer 20 are laminated is produced.

The piezoelectric layer 20 may be formed by a known method.

For example, in a case of the piezoelectric layer in which the piezoelectric particles 42 are dispersed in the polymer matrix 40, illustrated in Fig. 3, as an example, is produced as follows.

First, a coating material in which piezoelectric particles 42 are dispersed in a polymer material is prepared by dissolving a polymer material having viscoelasticity at room temperature such as cyanoethylated PVA in an organic solvent, adding the piezoelectric particles 42 such as PZT particles thereto, and stirring.

The organic solvent is not limited, and various organic solvents such as dimethylformamide (DMF), methyl ethyl ketone, and cyclohexanone can be used.

In a case where the second laminated sheet 18 is prepared and the coating material is prepared, the coating material is cast (applied) onto the second electrode layer 26 of the second laminated sheet 18 and the organic solvent is evaporated and dried. Accordingly, as illustrated in Fig. 5, a laminate 12a in which the second electrode layer 26 is provided on the second protective layer 30 and the piezoelectric layer 20 is formed on the second electrode layer 26 is produced.

A casting method of the coating material is not particularly limited, and all known coating methods (coating devices) such as a slide coater or a doctor knife are able to be used.

In a case where the polymer material is a material that is able to be heated and melted like cyanoethylated PVA, a melted material may be produced by heating and melting the polymer material and adding and dispersing the piezoelectric particles 42 therein, and the melted material is extruded into a sheet shape on the second laminated sheet 18 illustrated in Fig. 4 by extrusion molding or the like, and cooled, thereby producing the laminate 12a in which the first electrode layer 24 is provided on the first protective layer 28 and the piezoelectric layer 20 is formed on the first electrode layer 24 as illustrated in Fig. 5.

As described above, in the piezoelectric film 12, in addition to the polymer material having viscoelasticity at room temperature such as cyanoethylated PVA, a dielectric polymer material such as PVDF may be added to the polymer matrix 40.

In a case where the dielectric polymer material is added to the polymer matrix 40, the dielectric polymer material added to the above-mentioned coating material may be dissolved. Alternatively, the dielectric polymer material may be added to the heated and melted polymer material having a viscoelasticity at room temperature as described above so that the dielectric polymer material is heated and melted.

After the piezoelectric layer 20 is formed, a calendar treatment may be performed, if necessary. The calendar treatment may be performed once or a plurality of times.

As is well known, the calendar treatment is a treatment in which the surface to be treated is pressed while being heated by a heating press, a heating roller, or the like to flatten the surface.

Next, the piezoelectric layer 20 of the laminate 12a in which the second electrode layer 26 is provided on the second protective layer 30 and the piezoelectric layer 20 is formed on the second electrode layer 26 is subjected to the polarization treatment (poling). The polarization treatment of the piezoelectric layer 20 may be performed before the calendar treatment, but it is preferable that the polarization treatment is performed after the calendar treatment.

A method of performing a polarization treatment on the piezoelectric layer 20 is not limited, and a known method can be used. For example, electric field poling in which a DC electric field is directly applied to a target to be subjected to the polarization treatment is exemplified. In a case of performing electric field poling, the electric field poling treatment may be performed using the first electrode layer 24 and the second electrode layer 26 by forming the first electrode layer 24 before the polarization treatment.

In addition, in a case where the piezoelectric film 12 used in the laminated piezoelectric element 10 of the embodiment of the present invention is produced, in the polarization treatment, polarization is preferably performed in the thickness direction of the piezoelectric layer 20 instead of the surface direction.

On the other hand, the first laminated sheet 16 in which the first electrode layer 24 is formed on the first protective layer 28 is prepared.

This first laminated sheet 16 may be produced by forming a copper thin film or the like as the first electrode layer 24 on the surface of the first protective layer 28 using vacuum vapor deposition, sputtering, plating, or the like, similar to the second laminated sheet 18.

Next, as illustrated in Fig. 6, the first electrode layer 24 is directed toward the piezoelectric layer 20, and the first laminated sheet 16 is laminated on the laminate 12a after polarization treatment of the piezoelectric layer 20.

Furthermore, a laminate of the laminate 12a and the first laminated sheet 16 is interposed between the first protective layer 28 and the second protective layer 30, and is subjected to the thermal compression bonding using a heating press device, a heating roller pair, or the like to produce a piezoelectric film 12.

Here, as illustrated in Fig. 2, in the piezoelectric film 12, the first laminated sheet 16 has a first protruding portion 16a protruding from the piezoelectric layer 20, and the second laminated sheet 18 has a second protruding portion 18a protruding from the piezoelectric layer 20.

The piezoelectric film 12 having such a protruding portion can be produced by various methods.

As an example, there is exemplified a method of producing a piezoelectric film 12 in which a laminated sheet has a protruding portion by preparing the second laminated sheet on which the second protruding portion 18a is formed and the first laminated sheet 16 on which the first protruding portion 16a is formed, forming the piezoelectric layer 20 as described above on a site other than the second protruding portion 18a of the second laminated sheet 18, and laminating the first laminated sheet 16 thereon.

As another method, a method of producing a piezoelectric film 12 in which a laminated sheet has a protruding portion by producing a rectangular piezoelectric film, and then cutting thereof into a shape having a first protruding portionl6a and a second protruding portion 18a, removing the piezoelectric layer 20 and the second laminated sheet 18 corresponding to a position of the first protruding portion 16a, and removing the piezoelectric layer 20 and the first laminated sheet 16 corresponding to the position of the second protruding portion 18a can also be used.

The piezoelectric layer 20 may be removed by a known method according to the material for forming the piezoelectric layer 20, such as removal by peeling or dissolution with a solvent. The laminated sheet may be removed by a known method depending on the material for forming the laminated sheet, such as removal by peeling or cutting.

In the piezoelectric film 12, the first protruding portion 16a of the first laminated sheet 16 and the second protruding portion 18a of the second laminated sheet 18 are preferably separated from each other, viewed from the normal direction of the piezoelectric film 12. The normal direction of the piezoelectric film 12 is a direction orthogonal to a main surface of the piezoelectric film 12.

In other words, it is preferable that the first protruding portion 16a of the first laminated sheet 16 and the second protruding portion 18a of the second laminated sheet 18 appear not to overlap in a case of being observed from a direction orthogonal to the main surface of the piezoelectric film 12.

As described above, the first protruding portion 16a of the first laminated sheet 16 is exposed to the first electrode layer 24, and the second protruding portion 18a of the second laminated sheet 18 is exposed to the second electrode layer 26. Moreover, the first electrode layer 24 and the second electrode layer 26 face each other. In addition, the piezoelectric layer 20 has a preferable thickness of 10 to 300 µm, which is very thin.

Therefore, in a case where the first protruding portion 16a and the second protruding portion 18a overlap in the surface direction, the protruding portion is bent due to gravity, external force, or the like, and the first electrode layer 24 and the second electrode layer 26 of the protruding portion come into contact with each other and has a possibility of causing a short circuit.

On the other hand, since the first protruding portion 16a and the second protruding portion 18a are separated from each other in the surface direction, it is possible to suitably prevent a short circuit due to contact between the electrode layers of the protruding portions.

As described above, the first lead-out wire 34 is attached to the first protruding portion 16a of the first laminated sheet 16. On the other hand, the second lead-out wire 36 is attached to the second protruding portion 18a of the second laminated sheet 18.

Fig. 7 conceptually shows the vicinity of the protruding portion of the piezoelectric film 12.

Both the first lead-out wire 34 and the second lead-out wire 36 are a laminate of the conductive attaching layer 50 and the conductive layer 52.

The first lead-out wire 34 and the second lead-out wire 36 are, as a preferable example, a long rectangular member, that is, a band-like member. The first lead-out wire 34 and the second lead-out wire 36 are not limited to the band-like member, and may be a wire rod, or may be a member in which a plurality of wire rods are arranged or bundled.

In the first lead-out wire 34, the conductive attaching layer 50 on one end portion is attached to the first electrode layer 24 of the first protruding portion 16a and folded back upward in the drawing so that the conductive attaching layer 50 at the other end portion is attached to the first protective layer 28 of the first protruding portion 16a and is attached to the first protruding portion 16a. Therefore, the conductive layer 52 of the first lead-out wire 34, which is outside the folded-back, is electrically connected to the first electrode layer 24.

In the second lead-out wire 36, the conductive attaching layer 50 on one end portion is attached to the second electrode layer 26 of the second protruding portion 18a and folded back downward in the drawing so that the conductive attaching layer 50 at the other end portion is attached to the second protective layer 30 of the second protruding portion 18a and is attached to the second protruding portion 18a. Therefore, the conductive layer 52 of the second lead-out wire 36, which is outside the folded-back, is electrically connected to the second electrode layer 26.

In the first lead-out wire 34 and the second lead-out wire 36, the conductive attaching layer 50 is not limited, and various attaching layers having known conductivity can be used. The conductive attaching layer 50 may be a layer consisting of an adhesive, which will be described later, a layer consisting of a bonding agent, or a layer consisting of a material having properties of both agents.

As the conductive attaching layer 50, as an example, a bonding sheet obtained by dispersing metal particles in a bonding agent, a known conductive bonding sheet such as a conductive copper foil bonding tape and a conductive aluminum foil bonding tape, a known adhesive sheet, and the like can be used.

As the conductive attaching layer 50, a commercially available product can also be suitably used.

The thickness of the conductive attaching layer 50 is also not limited, and a thickness that provides sufficient flexibility, conductivity, and adhesive force may be appropriately set according to the forming material and the like.

The thickness of the conductive attaching layer 50 is preferably 5 to 500 µm, more preferably 15 to 300 µm, and even more preferably 20 to 100 µm.

In the first lead-out wire 34 and the second lead-out wire 36, the conductive layer 52 is not limited, and various types of known conductive materials can be used.

Examples of the conductive layer 52 include a sheet-like material, a layer, a wire rod, and the like consisting of various materials exemplified in the above-mentioned electrode layer.

The thickness of the conductive layer 52 is not limited, and a thickness at which sufficient flexibility and conductivity can be obtained may be appropriately set depending on the forming material and the like.

The thickness of the conductive layer 52 is preferably 10 to 750 µm, more preferably 20 to 500 µm, and even more preferably 30 to 300 µm.

The method of producing the first lead-out wire 34 and the second lead-out wire 36 is not limited.

As an example, a method of producing the first lead-out wire 34 and the second lead-out wire 36 by attaching the conductive layer 52 to the conductive attaching layer 50 by a bonding force of the conductive attaching layer 50 is exemplified.

Similar to the forming method of the above-mentioned first electrode layer 24 and the like, by forming the conductive layer 52 on a non-attaching surface of the conductive attaching layer 50 of which one surface is an attaching surface, the first lead-out wire 34 and the second lead-out wire 36 may be produced.

By attaching the conductive layer 52 with a conductive adhesive to the non-attaching surface of the conductive attaching layer 50 of which one surface is an attaching surface, the first lead-out wire 34 and the second lead-out wire 36 may be produced.

The first lead-out wire 34 and the second lead-out wire 36 are not limited to the laminate of the conductive attaching layer 50 and the conductive layer 52.

For example, the first lead-out wire 34 and/or the second lead-out wire 36 may be a single-layer sheet-like material such as a conductive bonding sheet formed by dispersing metal particles or the like in a bonding agent. In addition, the first lead-out wire 34 and/or the second lead-out wire 36 is formed only by the conductive layer 52, and one end of the lead-out wire and the electrode layer of the protruding portion are attached with a conductive paste or the like and electrically connected, and the other end of the lead-out wire and the protective layer of the protruding portion may be attached with an attaching agent (adhesive, bonding agent).

The lengths of the first lead-out wire 34 and the second lead-out wire 36 are also not limited.

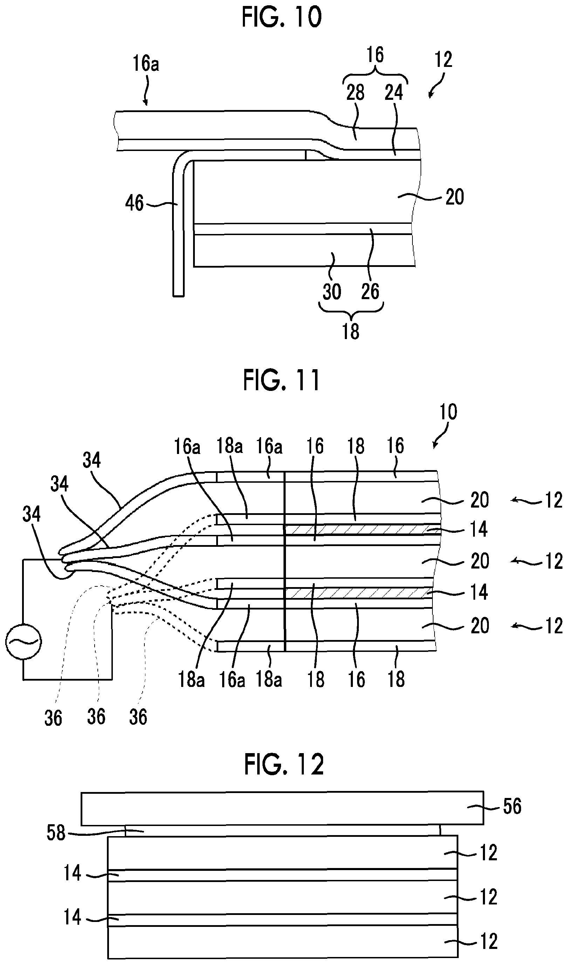

The lengths of the first lead-out wire 34 and the second lead-out wire 36 are such that in a case where a plurality of piezoelectric films 12 are laminated, a length at which the first lead-out wires 34 and the second lead-out wires 36 of all the piezoelectric film 12 can be in contact with each other may be appropriately set depending on the thickness of the piezoelectric film 12, the number of laminations of piezoelectric films, the position of the first protruding portion 16a of the first laminated sheet 16 of each piezoelectric film 12, the position of the second protruding portion 18a of the second laminated sheet 18 of each piezoelectric film 12, and the like, as illustrated in Fig. 11 to be described later.

The lengths of the first lead-out wire 34 and the second lead-out wire 36 are not limited because they differ depending on the size of the product and the environment in which they are used, but in consideration of the thickness and hardness of the product, the lengths are preferably 5 mm or more, more preferably 20 to 100 mm, and in consideration of the increase in resistance value and ease of use, the lengths are even more preferably 30 to 50 mm. These lengths are the lengths in a state where the first lead-out wire 34 and the second lead-out wire 36 are not folded back.

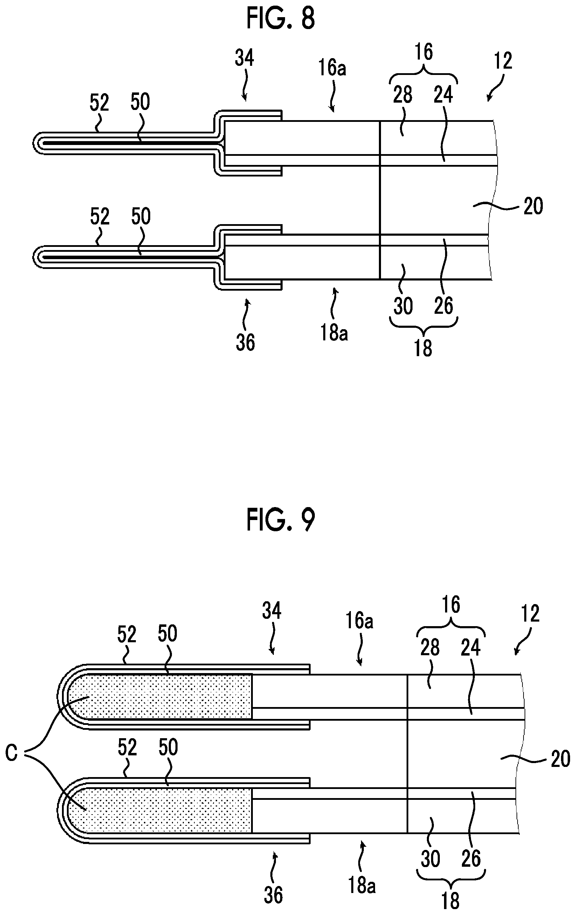

The first lead-out wire 34 and the second lead-out wire 36 may attach conductive attaching layers 50 to each other as necessary, as conceptually illustrated in Fig. 8.

In addition, the first lead-out wire 34 and the second lead-out wire 36 may interpose a core material C as a core between the folded lead-out wires, as conceptually illustrated in Fig. 9, if necessary. The material for forming the core material C is not limited, and examples thereof include PET, PC, polyoxymethylene (POM), PS, acrylonitrile-butadiene-styrene copolymer (ABS), PI, PP, and the like. The thickness of the core material C is also not limited, and may be appropriately set according to the lengths of the first lead-out wire 34 and the second lead-out wire 36 and the like.

As mentioned above, the first laminated sheet 16 and the second laminated sheet 18 are very thin. Therefore, if the first protruding portion 16a of the first laminated sheet 16 is bent due to its own weight, external force, or the like, the first electrode layer 24 of the first protruding portion 16a may come into contact with the second electrode layer 26 and there is a possibility of causing a short circuit. Similarly, the second electrode layer 26 of the second protruding portion 18a of the second laminated sheet 18 may come into contact with the first electrode layer 24 and there is a possibility of causing a short circuit.

In order to eliminate this inconvenience, as shown by exemplifying the side of the first laminated sheet 16 in Fig. 10, it is preferable to provide an insulating sheet 46 at a position corresponding to the first protruding portion 16a of the first laminated sheet 16, for example, toward the second laminated sheet 18 from between the first laminated sheet 16 and the piezoelectric layer 20. By having such an insulating sheet 46, the first protruding portion 16a of the first laminated sheet 16 is bent, and the first electrode layer 24 of the first protruding portion 16a comes into contact with the second electrode layer 26 and it is possible to prevent a short-circuit from being generated. In relation to this point, the same applies to the second protruding portion 18a of the second laminated sheet 18.

The insulating sheet 46 may be provided only corresponding to the first protruding portion 16a of the first laminated sheet 16, or may be provided corresponding only to the second protruding portion 18a of the second laminated sheet 18, and may be provided corresponding to both the first protruding portion 16a and the second protruding portion 18a.

The length of the insulating sheet 46 is not limited, and may be appropriately set according to the thickness of the piezoelectric film 12 and the like.

Explaining the first laminated sheet 16 as an example, in the insulating sheet 46, in a case where the length of a portion protruding from the piezoelectric layer 20 is denoted as LI, and the total thickness of the piezoelectric layer 20 and the second laminated sheet 18 is denoted as L2, it is preferable that the length satisfies "L1> L2".

As illustrated in Fig. 1, the laminated piezoelectric element of the embodiment of the present invention is a laminate obtained by laminating a plurality of such piezoelectric films 12. In the laminated piezoelectric element 10 of the illustrated example, three piezoelectric films 12 are laminated.

As shown in JP2015-15283A, in such a laminated piezoelectric element, a wire is required to be connected to the electrode layer so as to be connected to an external device such as an external power source for driving for each piezoelectric film. However, in a laminated piezoelectric element in which piezoelectric films are laminated, a method of simply connecting a wire on the electrode layer of each piezoelectric film is not known.

Here, in the laminated piezoelectric element in which the piezoelectric films are laminated, it is preferable that the wire of each piezoelectric film to the electrode layer is collectively connected for each electrode layer having the same polarity.

However, in a case where the piezoelectric film 12, in which the first laminated sheet 16 having the first electrode layer 24 and the first protective layer 28 and the second laminated sheet 18 having the second electrode layer 26 and the second protective layer 30 are provided facing the electrode layer, is laminated on both sides of the piezoelectric layer 20, a protective layer exists between the electrode layers having the same polarity, and thus it is difficult to connect the wire collectively to the electrode layers having the same polarity.

On the other hand, in the laminated piezoelectric element 10 of the embodiment of the present invention, the first laminated sheet 16 of the piezoelectric film 12 has the first protruding portion 16a. In addition, the piezoelectric film 12 has a band-like first lead-out wire 34, which is a laminate of the conductive attaching layer 50 and the conductive layer 52, in which one end of the conductive attaching layer 50 is attached to the first electrode layer 24 of the first protruding portion 16a and folded back, and the other end of the conductive attaching layer 50 is attached to the first protective layer 28 of the first protruding portion 16a.

In addition, the second laminated sheet 18 of the piezoelectric film 12 has the second protruding portion 18a. In addition, the piezoelectric film 12 has a band-like second lead-out wire 36, which is a laminate of the conductive attaching layer 50 and the conductive layer 52, in which one end of the conductive attaching layer 50 is attached to the second electrode layer 26 of the second protruding portion 18a and folded back, and the other end of the conductive attaching layer 50 is attached to the second protective layer 30 of the second protruding portion 18a.

In addition, in the laminated piezoelectric element 10 of the embodiment of the present invention, the first electrode layer 24 of each piezoelectric film 12 has the same polarity. Therefore, the second electrode layer 26 of each piezoelectric film 12 also has the same anti-polarity as that of the first electrode layer 24.

As described above, the conductive layer 52 of the first lead-out wire 34 which is outside the folded-back is electrically connected to the first electrode layer 24. Similarly, the conductive layer 52 of the second lead-out wire 36 which is outside the folded-back is electrically connected to the second electrode layer 26.

Therefore, in the laminated piezoelectric element 10 of the embodiment of the present invention, as conceptually illustrated in Fig. 11, after laminating a plurality of (three sheets in the illustrated example) piezoelectric films 12, the first lead-out wire 34 of all the piezoelectric films 12 is brought into contact with each other, and thus the wire of all the piezoelectric films 12 from the first electrode layer 24 can be combined into one. Similarly, after laminating the piezoelectric films 12, the second lead-out wire 36 of all the piezoelectric films 12 is brought into contact with each other, and thus the wire of all piezoelectric films from the second electrode layer 26 of all the piezoelectric films 12 from the second electrode layer 26 can be combined into one.

Therefore, by connecting any of the first lead-out wire 34 and the second lead-out wire 36 to the power source, an external device such as a power source can be connected to all the piezoelectric films 12 constituting the laminated piezoelectric element 10. That is, according to the present invention, in the laminated piezoelectric element 10 in which a plurality of piezoelectric films 12 are laminated, an external device such as a power source can be easily connected to all the piezoelectric films 12.

Moreover, in the laminated piezoelectric element 10 of the embodiment of the present invention, each piezoelectric film 12 is connected to the power source in parallel. Therefore, all the piezoelectric films 12 can be driven uniformly, and for example, in a case of being used as an exciter described later, highly efficient electroacoustic conversion can be performed.

In the laminated piezoelectric element 10 of the embodiment of the present invention, viewed from the normal direction, the first lead-out wire 34 of each piezoelectric film 12 may be seen apart, or at least a part thereof may be overlapped. That is, in the laminated piezoelectric element 10 of the embodiment of the present invention, the first lead-out wire 34 of each piezoelectric film 12 may be separated in the surface direction, or at least a part thereof may overlap in the surface direction.

The normal direction of the laminated piezoelectric element 10 is a direction orthogonal to the main surface of the laminated piezoelectric element 10. The surface direction of the laminated piezoelectric element 10 is a surface direction of the main surface of the laminated piezoelectric element 10. In addition, the main surface of the laminated piezoelectric element 10 is, that is, the main surface of the laminate of the piezoelectric film 12.

In the laminated piezoelectric element 10 of the embodiment of the present invention, it is preferable that a portion of the first lead-out wire 34 of each piezoelectric film 12 appears to overlap, viewed from the normal direction, and in terms of the area ratio, it is more preferable that 30% or more of the first lead-out wire 34 of each piezoelectric film 12 appears to overlap, it is even more preferable that 50% or more of the first lead-out wire 34 of each piezoelectric film 12 appears to overlap, and it is particularly preferable that the first lead-out wire 34 of all the piezoelectric films 12 appears to completely overlap.

In other words, the laminated piezoelectric element 10 of the embodiment of the present invention preferably has a portion where the first lead-out wire 34 of each piezoelectric film 12 overlaps in the surface direction, more preferably has a portion where 30% or more of the first lead-out wire 34 of each piezoelectric film 12 overlaps in the surface direction, even more preferably has a portion where 50% or more of the first lead-out wire 34 of each piezoelectric film 12 overlaps in the surface direction, and particularly preferably has a portion where the first lead-out wire 34 of each piezoelectric film 12 completely overlap in the surface direction.

In relation to this point, the same applies to the second lead-out wire 36.

By having such a configuration, by only laminating the piezoelectric film 12, by its own weight, for example, the first lead-out wires 34 and the second lead-out wires 36 of all the piezoelectric films 12 come into contact with each other.

In the laminated piezoelectric element 10 of the embodiment of the present invention, the contacted first lead-out wires 34 and the contacted second lead-out wires 36 may be adhered to each other.

There are no restrictions on the bonding method, and various bonding methods that can maintain the conductivity between the lead wires can be used.

As an example, a method of using a metal paste, a method of using a conductive adhesive, a method of using an adhesive tape, and the like are exemplified.

Examples of the metal paste include a metal paste in which metal particles such as silver, copper, and gold are dispersed in a binder consisting of a thermosetting resin such as epoxy resin and polyimide, a metal paste formed by dispersing similar metal particles in a binder consisting of resins cured at room temperature, such as acrylic resins, a metal paste which is thermally cured by a single metal with a complex metal, and the like.

As illustrated in Fig. 1, as a preferable aspect, the laminated piezoelectric element 10 of the embodiment of the present invention has a configuration in which a plurality of layers of piezoelectric films 12 are laminated and adjacent piezoelectric films 12 are attached to each other by the attaching layer 14. In the illustrated example, the laminated piezoelectric element 10 of the embodiment of the present invention has a configuration in which three layers of piezoelectric films 12 are laminated, and adjacent piezoelectric films 12 are attached by the attaching layer 14.

In the present invention, various known attaching layers 14 can be used as long as the adjacent piezoelectric films 12 can be attached.

Therefore, the attaching layer 14 may be a layer consisting of an adhesive, which has fluidity during bonding and thereafter becomes a solid, or may be a layer consisting of a bonding agent which is a gel-like (rubber-like) flexible solid during bonding and does not change in the gel-like state thereafter, or may be a layer consisting of a material having properties of both an adhesive and a bonding agent.

Here, the laminated piezoelectric element 10 of the embodiment of the present invention vibrates a vibration plate 56 as described later and generates a sound by stretching and contracting the plurality of laminated piezoelectric films 12. Therefore, in the laminated piezoelectric element 10 of the embodiment of the present invention, it is preferable that the stretching and contracting of each piezoelectric film 12 is directly transmitted. In a case where a substance having a viscosity that attenuates vibration is present between the piezoelectric films 12, the efficiency of transmitting the stretching and contracting energy of the piezoelectric film 12 is lowered, and the driving efficiency of the laminated piezoelectric element 10 is also decreased.

In consideration of this point, the attaching layer 14 is preferably an adhesive layer consisting of an adhesive with which a solid and hard attaching layer 14 is obtained, rather than a bonding layer consisting of a bonding agent. As a more preferable attaching layer 14, specifically, a bonding layer consisting of a thermoplastic type adhesive such as a polyester-based adhesive or a styrene-butadiene rubber (SBR)-based adhesive is suitably exemplified.

Adhesion is different from bonding, and is useful in a case where a high adhesion temperature is required. In addition, the thermoplastic type adhesive has "relatively low temperature, short time, and strong adhesion" and is suitable.

In the laminated piezoelectric element 10 of the embodiment of the present invention, the thickness of the bonding layer 14 is not limited, and a thickness capable of exhibiting sufficient bonding force (adhesive force or bonding force) may be appropriately set depending on the forming material of the bonding layer 14.

Here, in the laminated piezoelectric element 10 of the embodiment of the present invention, the thinner attaching layer 14 has a higher transmission effect of the stretching and contracting energy (vibration energy) of the piezoelectric layer 20, and can increase the energy efficiency. In addition, in a case where the attaching layer 14 is thick and has high rigidity, there is a possibility that the stretching and contracting of the piezoelectric film 12 may be constrained.

In consideration of this point, the attaching layer 14 is preferably thinner than the piezoelectric layer 20. That is, in the laminated piezoelectric element 10 of the embodiment of the present invention, the attaching layer 14 is preferably hard and thin.

Specifically, the thickness of the attaching layer 14 is preferably 0.1 to 100 µm, more preferably 10 to 75 µm, and even more preferably 25 to 50 µm in terms of thickness after bonding.

In the laminated piezoelectric element of the embodiment of the present invention, the attaching layer 14 is provided as a preferable aspect and is not an essential constituent element.

Therefore, the laminated piezoelectric element of the embodiment of the present invention does not have the attaching layer 14, and the laminated piezoelectric element may be configured by laminating and closely attaching the piezoelectric films 12 constituting the laminated piezoelectric element using a known pressure bonding unit, a fastening unit, a fixing unit, or the like.

However, in the present configuration, the individual piezoelectric films 12 stretch and contract independently in a case where a driving voltage is applied from the power source. As a result, in the present configuration, the driving efficiency of the laminated piezoelectric element decreases, the degree of stretching and contracting of the laminated piezoelectric element as a whole decreases, and there is a possibility that an abutting vibration plate or the like cannot sufficiently vibrate. In particular, in a case where each piezoelectric film 12 bends in an opposite direction to form a gap, the stretching and contracting of the laminated piezoelectric element as a whole becomes very small.

In consideration of this point, it is preferable that the laminated piezoelectric element of the embodiment of the present invention has the attaching layer 14 for attaching adjacent piezoelectric films 12 to each other, as in the laminated piezoelectric element 10 of the illustrated example.

As an example, as conceptually illustrated in Fig. 12, the laminated piezoelectric element 10 of the embodiment of the present invention is adhered to the vibration plate 56 by an attaching layer 58, and is used as an exciter for generating a sound from the vibration plate 56.

In an electroacoustic transducer using the laminated piezoelectric element of the embodiment of the present invention, the attaching layer 58 that attaches the laminated piezoelectric element 10 and the vibration plate 56 is not limited, and various known bonding agents and adhesives can be used. As an example, the same as the above-mentioned attaching layer 14 is exemplified.

In the electroacoustic transducer using the laminated piezoelectric element of the embodiment of the present invention, the vibration plate 56 is not limited, and various articles can be used.

As the vibration plate 56, for example, plate materials such as resin plates and glass plates, advertisement or notification media such as signboards, office devices and furniture such as tables, whiteboards, and projection screens, display devices such as organic electroluminescence (organic light emitting diode (OLED)) displays and liquid crystal displays, members for vehicles including automobiles such as consoles, A-pillars, roofs, and bumpers, and building materials such as walls of houses are exemplified.

Hereinabove, although the laminated piezoelectric element of the embodiment of the present invention is described in detail, the present invention is not limited to the above-mentioned examples, and various improvements and changes may be made within a range not departing from the gist of the present invention.

The laminated piezoelectric element can be suitably used as an exciter or the like that abuts on various members to generate a sound.

### Explanation of References

10: laminated piezoelectric element
12: piezoelectric film
12a: laminate
14,58: attaching layer
16: first laminated sheet
16a: first protruding portion
18: second laminated sheet
18a: second protruding portion
24: first electrode layer
26: second electrode layer
28: first protective layer
30: second protective layer
34: first lead-out wire
36: second lead-out wire
40: polymer matrix
42: piezoelectric particles
46: insulating sheet
50: conductive attaching layer
52: conductive layer
56: vibration plate

## Claims

1. A laminated piezoelectric element in which a plurality of piezoelectric films are laminated,
wherein the piezoelectric film includes a piezoelectric layer, a first laminated sheet in which a first electrode layer and an insulating first protective layer are laminated, and a second laminated sheet in which a second electrode layer and an insulating second protective layer are laminated, and the piezoelectric layer is positioned between the first laminated sheet and the second laminated sheet with the first electrode layer and the second electrode layer facing each other,
the first laminated sheet has a first protruding portion protruding from the piezoelectric layer, and the second laminated sheet has a second protruding portion protruding from the piezoelectric layer,
in the first protruding portion, one end of a first lead-out wire having conductivity is connected to a surface of the first electrode layer, and the other end is attached to the first protective layer such that the first lead-out wire reaches a surface of the first protective layer from the surface of the first electrode layer, and in the second protruding portion, one end of a second lead-out wire having conductivity is connected to a surface of the second electrode layer and the other end is attached to the second protective layer such that the second lead-out wire reaches a surface of the second protective layer from the surface of the second electrode layer, and
in the plurality of piezoelectric films, all of the first electrode layers are electrodes having the same polarity, all of the second electrode layers are electrodes having the same polarity, the first electrode layers are connected to each other by contacting the first lead-out wire, and the second electrode layers are connected to each other by contacting the second lead-out wire.

2. The laminated piezoelectric element according to claim 1,
wherein in a case where the plurality of laminated piezoelectric films are viewed from a normal direction of a laminate of the piezoelectric films, the first lead-out wires overlap each other and the second lead-out wires overlap each other.

3. The laminated piezoelectric element according to claim 1 or 2, comprising:
an attaching layer which attaches adjacent piezoelectric films to each other.

4. The laminated piezoelectric element according to any one of claims 1 to 3,
wherein the first lead-out wire and the second lead-out wire are laminates in which a conductive attaching layer and a conductive layer are laminated, and
the first lead-out wire, the conductive attaching layer is attached to the surface of the first electrode layer and the surface of the first protective layer, and in the second lead-out wire, the conductive attaching layer is attached to the surface of the second electrode layer and the surface of the second protective layer.

5. The laminated piezoelectric element according to any one of claims 1 to 4,
wherein the piezoelectric film has no in-plane anisotropy in piezoelectric properties.

6. The laminated piezoelectric element according to any one of claims 1 to 5,
wherein the piezoelectric layer is a polymer composite piezoelectric body having a polymer material and piezoelectric particles.

7. The laminated piezoelectric element according to claim 6,
wherein the polymer material has a cyanoethyl group.

8. The laminated piezoelectric element according to claim 7,
wherein the polymer material is cyanoethylated polyvinyl alcohol.
